# EUROPÄISCHE PATENTANMELDUNG

(11) **EP 1 798 300 A1**
(43) Veröffentlichungstag der Anmeldung: **20.06.2007**
(21) Anmeldenummer: 05027686.4
(22) Anmeldetag: 16.12.2005
(51) Int. Cl.: C22C 19/05, C23C 30/00

(54) **Legierung, Schutzschicht zum Schutz eines Bauteils gegen Korrosion und/oder Oxidation bei hohen Temperaturen und Bauteil**

(71) Anmelder: SIEMENS AKTIENGESELLSCHAFT, 80333 München (DE)
(72) Erfinder: Stamm, Werner, Dr., 45481 Mülheim an der Ruhr (DE)

(57) **Zusammenfassung**

Bekannte Schutzschichten mit hohem Cr-Gehalt und zusätzlich ein Silizium bilden Sprödphasen aus, die unter dem Einfluss von Kohlenstoff während des Einsatzes zusätzlich verspröden. Die erfindungsgemäße Schutzschicht (7) hat die Zusammensetzung 27% bis 29% Chrom, 7% bis 16% Aluminium, 0,5% bis 0,7% Yttrium und/oder zumindest ein Metall aus der Gruppe umfassend Scandium und die Elemente der Seltenen Erden, 0% bis 11% Rhenium, 0% bis 2,0% Silizium (Si) und Rest Nickel.

## Beschreibung

Die Erfindung betrifft eine Legierung gemäß Anspruch 1, eine Schutzschicht zum Schutz eines Bauteils gegen Korrosion und/oder Oxidation bei hohen Temperaturen gemäß Anspruch 17 und ein Bauteil gemäß Anspruch 18.

Die Erfindung bezieht sich insbesondere auf eine Schutzschicht für ein Bauteil, das aus einer Superlegierung auf Nickel- oder Kobaltbasis besteht.

Schutzschichten für metallische Bauteile, die deren Korrosionsbeständigkeit und/oder Oxidationsbeständigkeit erhöhen sollen, sind im Stand der Technik in großer Zahl bekannt. Die meisten dieser Schutzschichten sind unter dem Sammelnamen MCrAlY bekannt, wobei M für mindestens eines der Elemente aus der Gruppe umfassend Eisen, Kobalt und Nickel steht und weitere wesentliche Bestandteile Chrom, Aluminium und Yttrium.

Typische Beschichtungen dieser Art sind aus den US-Patenten 4,005,989 und 4,034,142 bekannt.

Die US 6,280,857 B1 offenbart eine Schutzschicht, die die Elemente Kobalt, Chrom und Aluminium auf Nickelbasis, die optionale Zugabe von Rhenium sowie zwingende Beimengungen von Yttrium und Silizium offenbart.

Die Bemühung um die Steigerung der Eintrittstemperaturen sowohl bei stationären Gasturbinen als auch bei Flugtriebwerken hat auf dem Fachgebiet der Gasturbinen eine große Bedeutung, da die Eintrittstemperaturen wichtige Bestimmungsgrößen für die mit Gasturbinen erzielbaren thermodynamischen Wirkungsgrade sind. Durch den Einsatz speziell entwickelter Legierungen als Grundwerkstoffe für thermisch hoch zu belastende Bauteile wie Leit- und Laufschaufeln, insbesondere durch den Einsatz einkristalliner Superlegierungen, sind Eintrittstemperaturen von deutlich über 1000°C möglich. Inzwischen erlaubt der Stand der Technik Eintrittstemperaturen von 950°C und mehr bei stationären Gasturbinen sowie 1100°C und mehr in Gasturbinen von Flugtriebwerken.

Beispiele zum Aufbau einer Turbinenschaufel mit einem einkristallinen Substrat, die seinerseits komplex aufgebaut sein kann, gehen hervor aus der WO 91/01433 A1.

Während die physikalische Belastbarkeit der inzwischen entwickelten Grundwerkstoffe für die hoch belasteten Bauteile im Hinblick auf mögliche weitere Steigerungen der Eintrittstemperaturen weitgehend unproblematisch ist, muss zur Erzielung einer hinreichenden Beständigkeit gegen Oxidation und Korrosion auf Schutzschichten zurückgegriffen werden. Neben der hinreichenden chemischen Beständigkeit einer Schutzschicht unter den Angriffen, die von Rauchgasen bei Temperaturen in der Größenordnung von 1000°C zu erwarten sind, muss eine Schutzschicht auch genügend gute mechanische Eigenschaften, nicht zuletzt im Hinblick auf die mechanische Wechselwirkung zwischen der Schutzschicht und dem Grundwerkstoff, haben. Insbesondere muss die Schutzschicht hinreichend duktil sein, um eventuellen Verformungen des Grundwerkstoffes folgen zu können und nicht zu reißen, da auf diese Weise Angriffspunkte für Oxidation und Korrosion geschaffen würden. Hierbei kommt typischerweise das Problem auf, dass eine Erhöhung der Anteile von Elementen wie Aluminium und Chrom, die die Beständigkeit einer Schutzschicht gegen Oxidation und Korrosion verbessern können, zu einer Verschlechterung der Duktilität der Schutzschicht führt, so dass mit einem mechanischen Versagen, insbesondere der Bildung von Rissen, bei einer in einer Gasturbine üblicherweise auftretenden mechanischen Belastung zu rechnen ist. Beispiele für die Verringerung der Duktilität der Schutzschicht durch die Elemente Chrom und Aluminium sind im Stand der Technik bekannt.

Dementsprechend liegt der Erfindung die Aufgabe zugrunde, eine Legierung und eine Schutzschicht anzugeben, die eine gute Hochtemperaturbeständigkeit in Korrosion und Oxidation aufweist, eine gute Langzeitstabilität aufweist und die außerdem einer mechanischen Beanspruchung, die insbesondere in einer Gasturbine bei einer hohen Temperatur zu erwarten ist, besonders gut angepasst ist.

Die Aufgabe wird gelöst durch eine Legierung gemäß Anspruch 1 und eine Schutzschicht gemäß Anspruch 17.

Eine weitere Aufgabe der Erfindung besteht darin, ein Bauteil aufzuzeigen, das einen erhöhten Schutz gegen Korrosion und Oxidation aufweist.

Die Aufgabe wird ebenso gelöst durch ein Bauteil gemäß Anspruch 18, insbesondere ein Bauteil einer Gasturbine oder Dampfturbine, das zum Schutz gegen Korrosion und Oxidation bei hohen Temperaturen einer Schutzschicht der vorbeschriebenen Art aufweist.

In den Unteransprüchen sind weitere vorteilhafte Maßnahmen aufgelistet.
Die in den Unteransprüchen aufgelisteten Maßnahmen können in vorteilhafter Art und Weise beliebig miteinander kombiniert werden.

Der Erfindung liegt u. a. die Erkenntnis zugrunde, dass die Schutzschicht in der Schicht und in dem Übergangsbereich zwischen Schutzschicht und Grundwerkstoff spröde Ausscheidungen zeigt. Diese mit der Zeit und Temperatur im Einsatz sich verstärkt ausbildenden Sprödphasen führen im Betrieb zu stark ausgeprägten Längsrissen in der Schicht als auch im Interface Schicht-Grundwerkstoff mit anschließender Ablösung der Schicht. Durch die Wechselwirkung mit Kohlenstoff, der aus dem Grundwerkstoff in die Schicht hineindiffundieren kann oder während einer Wärmebehandlung im Ofen durch die Oberfläche in die Schicht hineindiffundiert, erhöht sich zusätzlich die Sprödigkeit der Ausscheidungen.

Wichtig ist dabei auch der Einfluss von Nickel, die thermischen und mechanischen Eigenschaften bestimmt.

Die Erfindung wird im Folgenden näher erläutert.

Es zeigen
- Figur 1: ein Schichtsystem mit einer Schutzschicht,
- Figur 2: Zusammensetzungen von Superlegierungen,
- Figur 3: eine Gasturbine,
- Figur 4: eine Turbinenschaufel und
- Figur 5: eine Brennkammer.

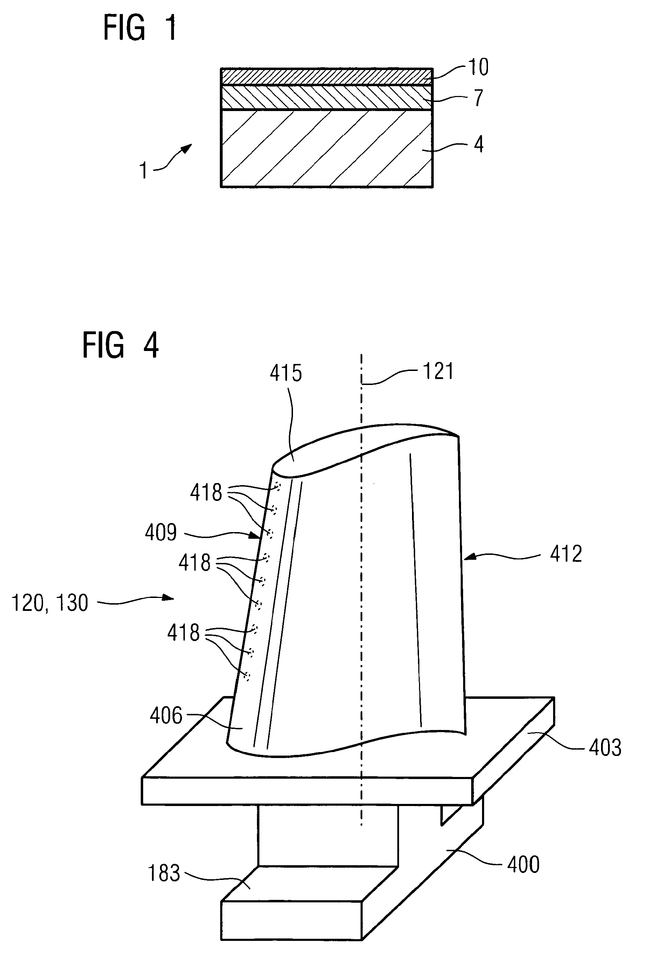

Erfindungsgemäß besteht eine Schutzschicht 7 (Fig. 1) zum Schutz eines Bauteils gegen Korrosion und Oxidation bei einer hohen Temperatur im Wesentlichen aus folgenden Elementen (Angabe der Anteile in wt%):
27% bis 29% Chrom
7% bis 16% Aluminium
0% bis 11% Rhenium
0% bis 2,0% Silizium
0,5% bis 0,7% Yttrium und/oder zumindest ein äquivalentes Metall aus der Gruppe umfassend Scandium und die Elemente der Seltenen Erden, Rest Nickel (NiCrAlY).
Dabei kann die vorteilhafte Wirkung des Elementes Rhenium unter Verhinderung der Sprödphasenbildung ausgenutzt werden. Vorzugsweise wird kein Kobalt verwendet.

In der Legierung können weitere Elemente hinzugefügt werden. Vorzugsweise besteht die Legierung jedoch nur aus den Elementen Nickel, Chrom, Aluminium, Yttrium sowie optional aus Silizium und/oder Rhenium.

Festzustellen ist, dass die Anteile der einzelnen Elemente besonders abgestimmt sind im Hinblick auf ihre Wirkungen, die in Zusammenhang Ausscheidungen zu sehen sind. Wenn die Anteile so bemessen sind, dass sich keine Ausscheidungen bilden, entstehen vorteilhafterweise keine Sprödphasen während des Einsatzes der Schutzschicht, so dass das Laufzeitverhalten verbessert und verlängert ist.
Dies geschieht nicht nur durch einen geringen Aluminiumgehalt, sondern auch, unter Berücksichtigung des Einflusses von Chrom auf die Phasenbildung, durch genaue Bemessung des Gehalts an Aluminium.
Die Auswahl von Nickel als Basis verbessert überraschend deutlich und überproportional die thermischen und mechanischen Eigenschaften der Schutzschicht 7.
Bei diesem eng ausgewählten Bereich an Nickel wird die Entstehung und weitere Bildung der y' Phase der Legierung besonders gut unterdrückt, die normalerweise zu einem Peak in dem thermischen Ausdehnungskoeffizienten der Legierung führt. Dieser Peak würde ansonsten beim Hochheizen des Bauteils mit der Schutzschicht 7 (Anfahren der Turbine) oder anderen Temperaturschwankungen hohe mechanische Spannungen (thermal mismatch) zwischen Schutzschicht 7 und Substrat 4 verursachen. Dies wird durch den erfindungsgemäß ausgewählten Nickelgehalt zumindest drastisch reduziert.

Vorteilhaft ist es, den Aluminiumanteil auf 8wt% festzulegen. Ebenso vorteilhaft ist es, den Anteil von Yttrium oder zumindest einem Element aus der Gruppe umfassend Scandium und der Elemente der seltenen Erde auf 0.6wt% festzulegen.

In Wechselwirkung mit der Reduzierung der Sprödphasen, die sich besonders unter höheren mechanischen Eigenschaften negativ auswirken, werden durch die Verringerung der mechanischen Spannungen durch den ausgewählten Nickel-Gehalt die mechanischen Eigenschaften verbessert.

Die Schutzschicht weist bei guter Korrosionsbeständigkeit eine besonders gute Beständigkeit gegen Oxidation auf und zeichnet sich auch durch besonders gute Duktilitätseigenschaften aus, so dass sie besonders qualifiziert ist für die Anwendung in einer Gasturbine bei einer weiteren Steigerung der Eintrittstemperatur. Während des Betriebs kommt es kaum zu einer Versprödung, da die Schicht kaum Ausscheidungen aufweist, die im Laufe des Einsatzes verspröden.

Besonders günstig ist es dabei jeweils den Chromgehalt auf 28wt%, den Aluminiumgehalt auf 8wt%, 12wt%, 13wt% oder 15wt% und/oder den Yttrium-Gehalt auf 0,6wt% festzulegen. Gewisse Schwankungen ergeben sich aufgrund großindustrieller Herstellung, so dass auch Yttriumgehalte von 0,4wt% bis 0,5wt% bzw. 0,7wt% bis 0,8wt% verwendet werden und ebenfalls gute Eigenschaften zeigen.
Vorzugsweise werden auch Werte von 3wt% für Rhenium verwendet.

Besonders gute Ausführungsbeispiele sind (in wt%):
1) Ni - 28Cr - 12A1 - 0.6Y - (1-10)Re
2) Ni - 28Cr - 12A1 - 0.6Y - (1-10)Re - 1.5Si
3) Ni - 28Cr - 13Al - 0.6Y - 3Re
4) Ni - 28Cr - 15Al - 0.6Y
5) Ni - 28Cr - 15Al - 0.6Y - (1-10)Re
6) Ni - 28Cr - 8Al - 0.6Y - 3Re

Die Pulver werden beispielsweise durch Plasmaspritzen aufgebracht (APS, LPPS, VPS, ...) . Andere Verfahren sind ebenso denkbar (PVD, CVD, Kaltgasspritzen).

Die Dicke der Schutzschicht 7 auf dem Bauteil 1 wird vorzugsweise auf einen Wert zwischen etwa 100µm und 300µm bemessen.

Bei diesem Bauteil ist die Schutzschicht 7 vorteilhafterweise aufgetragen auf ein Substrat 4 aus einer Superlegierung auf Nickel- oder Kobaltbasis.
Als Substrat kommt insbesondere folgende Zusammensetzung in Frage (Angaben in wt%):
0,1% bis 0,15% Kohlenstoff
18% bis 22% Chrom
18% bis 19% Kobalt
0% bis 2% Wolfram
0% bis 4% Molybdän
0% bis 1,5% Tantal
0% bis 1% Niob
1% bis 3% Aluminium
2% bis 4% Titan
0% bis 0,75% Hafnium
wahlweise geringe Anteile von Bor und/oder Zirkon, Rest Nickel.
Zusammensetzungen dieser Art sind als Gusslegierungen unter den Bezeichnungen GTD222, IN939, IN6203 und Udimet 500 bekannt.

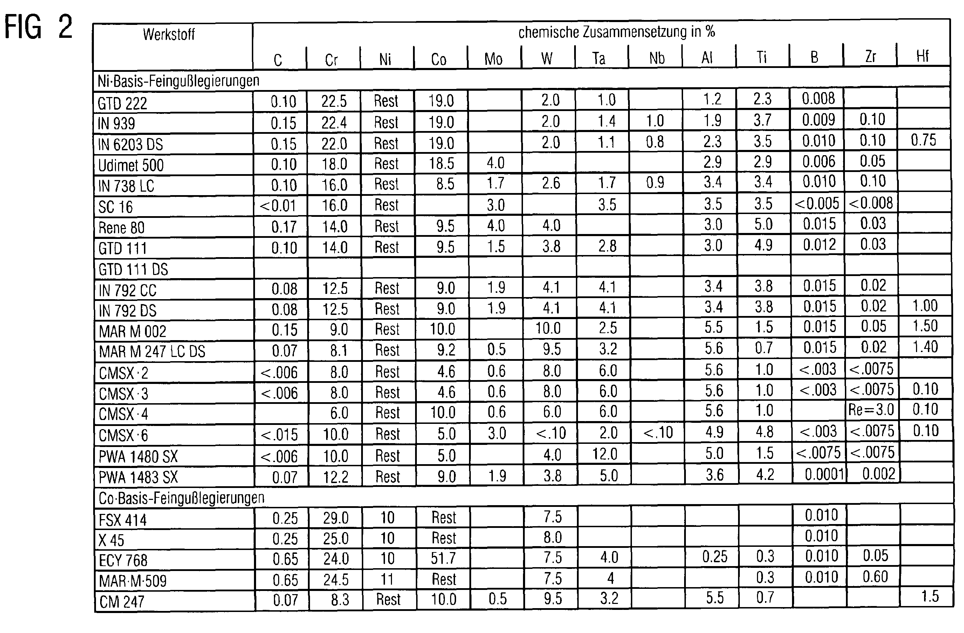

Weitere Alternativen für das Substrat des Bauteils sind in Figur 2 aufgelistet.

Die Schutzschicht 7 eignet sich besonders zum Schutz eines Bauteils gegen Korrosion und Oxidation, während das Bauteil bei einer Materialtemperatur um etwa 950°C, bei Flugturbinen auch um etwa 1100°C, mit einem Rauchgas beaufschlagt wird.

Die Schutzschicht 7 gemäß der Erfindung ist damit besonders qualifiziert zum Schutz eines Bauteils einer Gasturbine 100, insbesondere einer Leitschaufel 120, Laufschaufel 130 oder anderen Komponente, die mit heißem Gas vor oder in der Turbine der Gasturbine beaufschlagt wird.
Die Schutzschicht 7 kann als overlay (Schutzschicht ist die äußere Schicht oder als Bondcoat (Schutzschicht ist eine Zwischenschicht) verwendet werden.

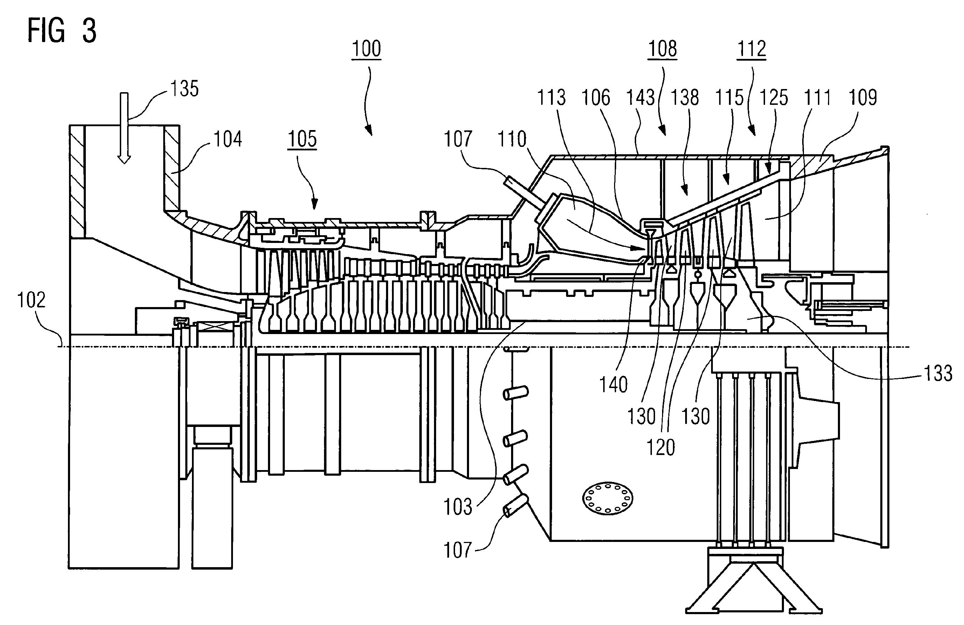

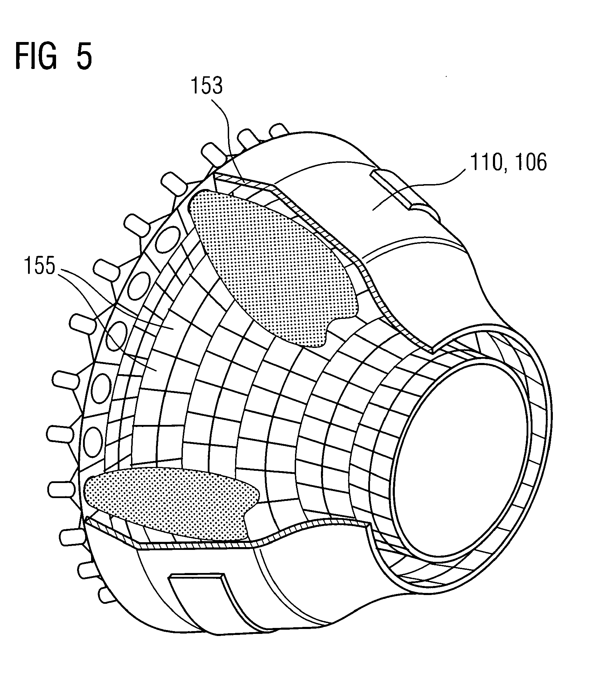

Figur 1 zeigt als ein Bauteil ein Schichtsystem 1.
Das Schichtsystem 1 besteht aus einem Substrat 4.
Das Substrat 4 kann metallisch und/oder keramisch sein. Insbesondere bei Turbinenbauteilen, wie z.B. Turbinenlauf- 120 (Fig. 4) oder -leitschaufeln 130 (Fig. 3, 4), Brennkammerauskleidungen 155 (Fig. 5) sowie anderen Gehäuseteilen einer Dampf- oder Gasturbine 100 (Fig. 3), besteht das Substrat 4 aus einer nickel- oder kobalt- Superlegierung.
Vorzugsweise werden kobaltbasierte Superlegierungen verwendet.

Auf dem Substrat 4 ist die erfindungsgemäße Schutzschicht 7 vorhanden.
Vorzugsweise wird diese Schutzschicht 7 durch LPPS (low pressure plasma spraying) aufgebracht.
Diese kann als äußere Schicht (nicht dargestellt) oder Zwischenschicht (Fig. 1) verwendet werden.
Im letzteren Fall ist auf der Schutzschicht 7 eine keramische Wärmedämmschicht 10 vorhanden.
Die Schutzschicht 7 kann auf neu hergestellte Bauteile und wiederaufgearbeitete Bauteile aus dem Refurbishment aufgebracht werden.
Wiederaufarbeitung (Refurbishment) bedeutet, dass Bauteile 1 nach ihrem Einsatz gegebenenfalls von Schichten (Wärmedämmschicht) getrennt werden und Korrosions- und Oxidationsprodukte entfernt werden, beispielsweise durch eine Säurebehandlung (Säurestrippen). Gegebenenfalls müssen noch Risse repariert werden. Danach kann ein solches Bauteil wieder beschichtet werden, da das Substrat 4 sehr teuer ist.

Die Figur 3 zeigt beispielhaft eine Gasturbine 100 in einem Längsteilschnitt.
Die Gasturbine 100 weist im Inneren einen um eine Rotationsachse 102 drehgelagerten Rotor 103 mit einer Welle 101 auf, der auch als Turbinenläufer bezeichnet wird.

Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.
Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.
Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.
Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).
Als Material für die Bauteile, insbesondere für die Turbinenschaufel 120, 130 und Bauteile der Brennkammer 110 werden beispielsweise eisen-, nickel- oder kobaltbasierte Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierungen Teil der Offenbarung.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

Die Figur 4 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.

Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierung Teil der Offenbarung.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt; diese Schriften sind bzgl. des Erstarrungsverfahrens Teil der Offenbarung.

Ebenso können die Schaufeln 120, 130 erfindungsgemäße Schutzschichten 7 gegen Korrosion oder Oxidation aufweisen. Die Dichte liegt vorzugsweise bei 95% der theoretischen Dichte. Auf der MCrAlX-Schicht (als Zwischenschicht oder als äußerste Schicht) bildet sich eine schützende Aluminiumoxidschicht (TGO = thermal grown oxide layer).

Auf der MCrAlX kann noch eine Wärmedämmschicht vorhanden sein, die vorzugsweise die äußerste Schicht ist, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Die Wärmedämmschicht bedeckt die gesamte MCrAlX-Schicht. Durch geeignete Beschichtungsverfahren wie z.B. Elektronenstrahlverdampfen (EB-PVD) werden stängelförmige Körner in der Wärmedämmschicht erzeugt.

Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAlX-Schicht.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

Die Figur 5 zeigt eine Brennkammer 110 der Gasturbine 100. Die Brennkammer 110 ist beispielsweise als so genannte Ringbrennkammer ausgestaltet, bei der eine Vielzahl von in Umfangsrichtung um eine Rotationsachse 102 herum angeordneten Brennern 107 in einen gemeinsamen Brennkammerraum 154 münden, die Flammen 156 erzeugen. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Aufgrund der hohen Temperaturen im Inneren der Brennkammer 110 kann zudem für die Hitzeschildelemente 155 bzw. für deren Halteelemente ein Kühlsystem vorgesehen sein. Die Hitzeschildelemente 155 sind dann beispielsweise hohl und weisen ggf. noch in den Brennkammerraum 154 mündende Kühllöcher (nicht dargestellt) auf.

Jedes Hitzeschildelement 155 aus einer Legierung ist arbeitsmediumsseitig mit einer besonders hitzebeständigen Schutzschicht (MCrAlX-Schicht und/oder keramische Beschichtung) ausgestattet oder ist aus hochtemperaturbeständigem Material (massive keramische Steine) gefertigt.
Diese Schutzschichten können ähnlich der Turbinenschaufeln sein, also bedeutet beispielsweise MCrAlX: M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf). Solche Legierungen sind bekannt aus der EP 0 486 489 B1, EP 0 786 017 B1, EP 0 412 397 B1 oder EP 1 306 454 A1, die bzgl. der chemischen Zusammensetzung der Legierung Teil dieser Offenbarung sein sollen.

Auf der MCrAlX kann noch eine beispielsweise keramische Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.
Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen.

Wiederaufarbeitung (Refurbishment) bedeutet, dass Turbinenschaufeln 120, 130, Hitzeschildelemente 155 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse in der Turbinenschaufel 120, 130 oder dem Hitzeschildelement 155 repariert. Danach erfolgt eine Wiederbeschichtung der Turbinenschaufeln 120, 130, Hitzeschildelemente 155 und ein erneuter Einsatz der Turbinenschaufeln 120, 130 oder der Hitzeschildelemente 155.

## Patentansprüche

1. Legierung
die folgende Elemente enthält
(in wt%) :
27% bis 29% Chrom (Cr)
7% bis 16% Aluminium (Al)
0,5% bis 0,7% Yttrium (Y) und/oder zumindest ein Metall aus der Gruppe umfassend Scandium (Sc) und die Elemente der Seltenen Erden,
0% bis 11% Rhenium (Re)
0% bis 2,0% Silizium (Si)
Rest Nickel (Ni).

2. Legierung nach Anspruch 1,
enthaltend 28wt% Chrom.

3. Legierung nach Anspruch 1 oder 2,
enthaltend
0,6wt% Yttrium und/oder ein Metall aus der Gruppe umfassend Scandium und die Elemente der Seltenen Erden.

4. Legierung nach Anspruch 1, 2 oder 3,
enthaltend 7wt% bis 9wt% Aluminium,
insbesondere 8wt% Aluminium.

5. Legierung nach Anspruch 1, 2 oder 3,
enthaltend 11wt% bis 13wt% Aluminium,
insbesondere 12wt% Aluminium.

6. Legierung nach Anspruch 1, 2 oder 3,
enthaltend 12wt% bis 14wt% Aluminium,
insbesondere 13wt% Aluminium.

7. Legierung nach Anspruch 1, 2 oder 3,
enthaltend 14wt% bis 16wt% Aluminium,
insbesondere 15wt% Aluminium.

8. Legierung nach einem oder mehreren der vorherigen Ansprüche,
enthaltend 1.0wt% bis 2.0wt% Silizium,
insbesondere 1.5wt% Silizium.

9. Legierung nach einem oder mehreren der vorherigen Ansprüche 1 bis 7,
enthaltend kein Silizium.

10. Legierung nach einem oder mehreren der vorherigen Ansprüche,
enthaltend kein Rhenium.

11. Legierung nach einem oder mehreren der vorherigen Ansprüche 1 bis 9,
enthaltend Rhenium.

12. Legierung nach Anspruch 1 oder 11,
enthaltend 1wt% bis 2wt% Rhenium,
insbesondere 2wt% Rhenium.

13. Legierung nach Anspruch 1 oder 11,
enthaltend 2wt% bis 4wt% Rhenium,
insbesondere 3wt% Rhenium.

14. Legierung nach Anspruch 1 oder 11,
enthalten 9wt% bis 11wt% Rhenium,
insbesondere 10wt% Rhenium.

15. Legierung nach einem oder mehreren der vorherigen Ansprüche,
die kein Kobalt enthält.

16. Legierung nach einem oder mehreren der vorherigen Ansprüche,
bestehend aus Nickel, Chrom, Aluminium, Yttrium sowie optional Rhenium und/oder Silizium.

17. Schutzschicht zum Schutz eines Bauteils (1, 120, 130, 138, 155) gegen Korrosion und/oder Oxidation, insbesondere bei hohen Temperaturen,
die die Zusammensetzung der Legierung gemäß einem oder mehreren der Ansprüche 1 bis 16 aufweist.

18. Bauteil,
insbesondere ein Bauteil (1, 120, 130, 138, 155) einer Gasturbine (100),
das zum Schutz gegen Korrosion und Oxidation bei hohen Temperaturen eine Schutzschicht (7) nach Anspruch 17 aufweist.

19. Bauteil nach Anspruch 18,
bei dem auf der Schutzschicht (7) eine Wärmedämmschicht (10) aufgebracht ist.

20. Bauteil nach Anspruch 18 oder 19,
bei dem ein Substrat (4) des Bauteils (1, 120, 130, 138, 155) nickelbasiert ist.

21. Bauteil nach Anspruch 17 oder 19,
bei dem ein Substrat (4) des Bauteils (1, 120, 130, 138, 155) kobaltbasiert ist.
